Europäisches Patentamt

**(19)** European Patent Office        **(11)** Numéro de publication: **0 197 595**
**B1**
Office européen des brevets

**(12)** FASCICULE DE BREVET EUROPEEN

**(45)** Date de publication du fascicule du brevet:        **(51)** Int. Cl.⁵: **H05K 3/42**, H05K 3/12
10.10.90

**(21)** Numéro de dépôt: 86200532.9

**(22)** Date de dépôt: 01.04.86

**(54)** Procédé de métallisation des trous servant de liaisons entre les faces d'un substrat en couche épaisse, simultanément à l'opération de sérigraphie.

**(30)** Priorité: 05.04.85 FR 8505262

**(43)** Date de publication de la demande:
15.10.86 Bulletin 86/42

**(45)** Mention de la délivrance du brevet:
10.10.90 Bulletin 90/41

**(84)** Etats contractants désignés:
BE CH DE FR GB IT LI NL SE

**(56)** Documents cités:
DE-A- 3 245 458
DE-A- 3 420 966
GB-A- 2 030 007

**(73)** Titulaire: **TRT TELECOMMUNICATIONS
RADIOELECTRIQUES ET TELEPHONIQUES, 88 rue
Brillat Savarin, F-75013 Paris(FR)**
**(84)** Etats contractants désignés: **FR**

**(73)** Titulaire: **N.V. Philips' Gloeilampenfabrieken,
Groenewoudseweg 1, NL-5621 BA Eindhoven(NL)**
**(84)** Etats contractants désignés: **BE CH DE GB IT LI NL SE**

**(72)** Inventeur: **Bourgeois-Moine, Jean-Paul, SOCIETE
CIVILE S.P.I.D. 209 rue de l'Université, F-75007 Paris(FR)**
Inventeur: **Bonnet, Jean-Marcel, SOCIETE CIVILE
S.P.I.D. 209 rue de l'Université, F-75007 Paris(FR)**

**(74)** Mandataire: **Chaffraix, Jean et al, Société Civile
S.P.I.D. 156, Boulevard Haussmann, F-75008 Paris(FR)**

## Description

L'invention concerne un procédé pour effectuer une grande quantité de métallisations interfaciales ou pariétales des trous ou cavités d'un substrat dans la technique des couches épaisses par sérigraphie, ledit substrat étant maintenu fixe par la création d'une dépression dans la chambre étanche porte-substrat du dispositif de sérigraphie, la viscosité de la pâte conductrice ayant une valeur appropriée et l'aspiration de ladite pâte dans les trous et/ou cavités prépercés étant effectuée au moyen d'un appareil pouvant y établir un fort débit d'air sous faible dépression, comme décrit dans le document DE-A-3 420 966.

La conception de circuits électriques sur tout substrat par la technique des couches épaisses implique de savoir réaliser des liaisons électriques multicouches et/ou interfaces fiables.

Les progrès apportés dans l'usinage des trous par l'introduction du laser ont permis d'augmenter le nombre de trous par unité de surface dans de très grandes proportions, passant de 1 à 3 trous par cm² à 4 à 10 trous par cm², voire davantage.

La réalisation d'interconnexions interfaciales nécessite une ou plusieurs métallisations successives des trous. On se limite habituellement à une métallisation par face.

Le procédé de métallisation le plus simple consiste à réduire la viscosité de la pâte à sérigraphier de façon à faciliter son écoulement dans les trous en même temps qu'elle est étalée sur la surface du circuit sous l'action de la raclette, mais on se trouve très vite limité par des difficultés d'enduction en surface.

Dans le procédé le plus couramment utilisé une dépression est créée à l'aide d'une pompe à vide dans une chambre étanche sous le substrat percé pendant l'opération de sérigraphie. La pâte pénètre ainsi dans les trous à faible débit par l'action d'une forte dépression qui sert également à tenir le substrat. La pénétration de la pâte est dépendante des paramètres de la sérigraphie, du nombre et de la répartition des trous. Il s'avère que l'utilisation de cette dépression est insuffisante pour métalliser un grand nombre de trous par uni-té de surface.

Un autre procédé plus fiable tel que celui mentionné dans le préambule consiste à aspirer la pâte au moyen d'un fort débit d'air. Dans ce procédé connu par exemple du brevet allemand n° 3 245 458, la sérigraphie du circuit et l'aspiration dans les trous sont réalisées en deux temps séparés sur deux équipements différents.

Pour pallier l'inconvénient d'une réalisation en deux opérations distinctes de la sérigraphie du circuit et des liaisons interfaces par métallisation des trous, le procédé de l'invention selon la revandication 1, offre la possibilité d'effectuer les métallisations sur la machine de sérigraphie elle-même et dans le même temps que l'impression de la pâte sur le substrat.

Ce procédé est remarquable en ce que le fort débit d'air fourni par ledit appareil est envoyé dans la chambre étanche porte-substrat simultanément à l'opération de sérigraphie pour transférer ladite pâte de l'écran de sérigraphie sur ledit substrat et pour provoquer son dépôt sur celui-ci et son nappage optimal sur les parois desdits trous et/ou cavités, en complément de l'action de la raclette du dispositif de sérigraphie.

Ledit appareil utilisé pour faire circuler de l'air à fort débit et à faible dépression est une turbine à gaz à variateur de vitesse, les paramètres physiques de la veine d'air (vitesse et/ou débit) étant obtenus au moyen d'un équipement de mesure et de contrôle permanent comportant entre autres sur le trajet de circulation d'air en amont de la turbine une sonde et son indicateur adaptés.

La mesure desdits paramètres physiques permet le contrôle de l'enduction de la pâte dans l'épaisseur du substrat et la modification de sa viscosité selon les valeurs des autres paramètres de sérigraphie, la densité et la dimension des trous et/ou cavités dudit substrat.

Ainsi le procédé connu consistant à aspirer la pâte à sérigraphier dans les trous par de l'air à grande vitesse permet de métalliser un grand nombre de trous (15 au cm²) avec une bonne fiabilité.

La réalisation simultanée selon l'invention de la sérigraphie de la pâte sur le substrat et de l'aspiration de la pâte dans les trous au moyen d'une turbine à gaz donnant un grand débit sous une faible dépression assure le transfert d'une grande quantité d'énergie disponible pour déplacer la pâte dans les trous et provoquer le nappage optimal des parois. La quantité d'encre transférée de l'écran sur le circuit est ainsi accrue par complémentarité de l'action du gaz en mouvement à l'action normale de la raclette. En conséquence, il est possible de choisir des tamis à mailles plus fines (325 mesh au lieu de 200) et donc d'augmenter la définition, c'est-à-dire le pouvoir de résolution des pistes et des lunules.

La création et la mise en place d'un dispositif de contrôle des paramètres physiques de la veine d'air: cellule de mesure locale des vitesses (anémomètre) et/ou des débits (débitmètre) adaptée au dispositif d'aspiration et associée à un indicateur standard (colonne manométrique ou manomètre), permet à tout instant un réglage fin de ces paramètres par un système de fuite ajustable en fonction du nombre de trous et des paramètres de sérigraphie (paramètres de la machine et paramètres de l'encre).

Le contrôle précis de la vitesse et/ou du débit d'air permet l'établissement d'un abaque définissant les réglages en fonction du nombre de trous à métalliser et de leurs diamètres.

Enfin la mise en oeuvre du procédé est peu onéreuse et s'adapte aisément à toute machine de sérigraphie en couche épaisse surtout si celle-ci est déjà équipée d'une chambre porte-substrat branchée sur un réseau de vide.

La description suivante en regard des dessins annexés, le tout donné à titre d'exemple fera bien comprendre comment l'invention peut être réalisée.

La figure 1 montre une vue en coupe verticale de la machine à sérigraphier.

La figure 2 représente une vue schématique de l'ensemble du dispositif pour la mise en œuvre du procédé de l'invention.

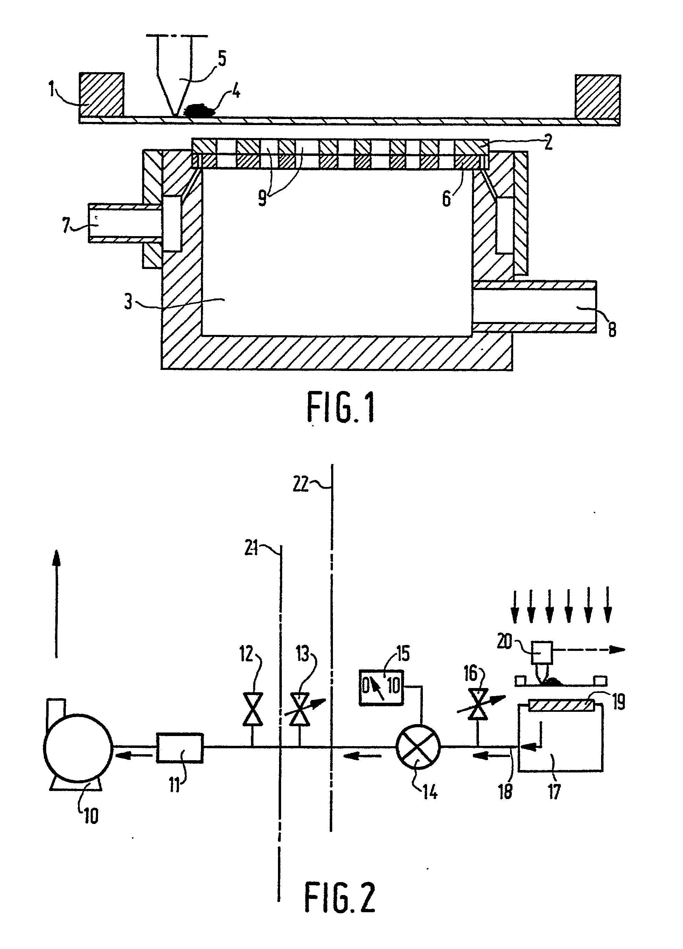

La machine à sérigraphier vue en coupe verticale sur la figure 1 comporte l'écran tamis 1 portant l'image du circuit à sérigraphier et disposé au-dessus de la chambre porte-substrat 3. Le tamis 1 porte la pâte à sérigraphier 4 devant être étalée sur le substrat au moyen de la raclette 5. La face supérieure de la chambre porte-substrat 3 est constituée par le substrat percé 2 reposant sur la contreplaque 6 qui lui est adaptée. La contreplaque 6 est reliée par ses bords à une sortie 7 communiquant avec une pompe à vide non représentée. Selon l'invention la chambre à vide 3 est munie d'une sortie 8 reliée à une turbine à gaz non représentée pour l'aspiration d'air à grande vitesse. Au cours de l'opération de sérigraphie, l'écran tamis 1 est descendu verticalement jusqu'à ce qu'il arrive au contact du substrat 2, tandis que la raclette 5 est déplacée horizontalement de façon à étaler la pâte 4 sur le substrat 2 et à la faire pénétrer à l'intérieur des trous 9 prépercés dans le substrat.

Le schéma général de principe de l'installation pour la mise en œuvre du procédé de l'invention comporte (figure 2) :

- une turbine à gaz 10 à vitesse variable qui déplace l'air dans un tube de 30 mm de diamètre avec un débit de $4 \cdot 10^{-2}$ m³.s⁻¹ et sous une pression de $2 \cdot 10^4$ Pascal.

- un système de fuite constante permanente 11 pour protéger le moteur de la turbine pendant les périodes où le débit est faible en amont (ce système est facultatif si le moteur de la turbine est équipé d'un circuit de refroidissement).

- une vanne 3 voies 12 assurant la fonction marche-arrêt de l'aspiration de l'air à travers le substrat. Le fonctionnement de cette vanne peut être manuel lorsqu'elle doit être installée près de la machine à sérigraphier. Elle sert alors à arrêter l'aspiration au niveau de la plaque porte-substrat. Le même fonctionnement peut être électrique si le système est logeable dans un local technique. Il est alors commandé depuis la machine de sérigraphie.

- un système de fuite réglable 13 assurant l'adaptation de la vitesse (ou du débit) d'air en fonction du nombre de trous percés dans le substrat.

- une cellule de mesure des pressions ou des vitesses 14,

- un indicateur des pressions ou des vitesses 15 : colonne manométrique, manomètre ou indicateur adapté à la cellule de mesure 14.

- une vanne 3 voies manuelle, ajustable 16 constituant un adaptateur du zéro de la cellule de mesure de pression.

- la chambre porte-substrate étanche 17 sur laquelle la canalisation d'aspiration 18 est raccordée. Elle reçoit sur sa face supérieure le substrat à métalliser 19, substrat prépercé que l'on pose en appui dans un logement de la chambre 17.

- l'ensemble 20 de l'écran et de la raclette de la machine à sérigraphier.

Les flèches en trait plein indiquent le sens d'écoulement d'air.

La flèche en traits pointillés indique le sens du déplacement de la raclette.

Le bruit produit par le déplacement du fluide impose la nécessité de placer une partie du matériel de cette installation en galerie technique. Selon que la vanne 13 est à commande manuelle ou à fonctionnement électrique, les éléments de l'installation placés en galerie technique sont situés à gauche du trait mixte 21 ou à gauche du trait mixte 22.

Enfin du fait de l'augmentation du risque de contamination de la pâte par les poussières environnantes, il est indispensable de travailler en salle propre (classe supérieure à 10 000 U.S.).

## Revendications

1. Procédé pour effectuer une grande quantité de métallisations interfaciales ou pariétales des trous ou cavités d'un substrat dans la technique des couches épaisses par sérigraphie, ledit substrat étant maintenu fixe par la création d'une dépression dans la chambre étanche porte-substrat du dispositif de sérigraphie, la viscosité de la pâte conductrice ayant une valeur appropriée et l'aspirator de ladite pâte dans les trous et/ou cavités prépercés étant effectuée au moyen d'un appareil pouvant y établir un fort débit d'air sous faible dépression, caractérisé en ce que ledit appareil utilisé pour faire circuler de l'air à fort débit et à faible dépression est une turbine à gaz à variateur de vitesse, les paramètres physiques de la veine d'air (vitesse et/ou débit) étant obtenus au moyen d'un équipement de mesure et de contrôle permanent comportant entre autres sur le trajet de circulation d'air en amont de la turbine une sonde et son indicateur adaptés, et que le for débit d'air fourni par ledit appareil est envoyé dans la chambre étanche portre-substrat simultanément à l'opération de sérigraphie pour transférer ladite pâte de l'écran de sérigraphie sur ledit substrat et pour provoquer son dépôt sur celui-ci et son nappage optimal sur les parois desdits trous et/ou cavités, en complément de l'action de la raclette du dispositif de sérigrahie.

2. Procédé selon la revendication 1, caractérisé en ce que la mesure desdits paramètres physiques permet le contrôle de l'enduction de la pâte dans l'épaisseur du substrat et la modification de sa viscosité selon les valeurs des autres paramètres de sérigraphie, la densité et la dimension des trous et/ou cavités dudit substrat.

## Claims

1. A process for perfoming a large number of plating-through or wall-plating operations in holes or cavities in a substrate by means of the thick-film, silk-screen printing technique, the said substrate being held in position by the creation of a partial vacuum in the airtight, substrate-holding chamber of the screen-printing device, the viscositiy of the conductive paste being of a suitable value and the suction of the said paste into the pre-drilled holes and/or cavities being effected by means of an apparatus capable of setting up a powerful airflow at slight underpressure in said holes, and/or cavities, characterized in that the said apparatus used to circulate the air with a powerful flow and at a slight underpressure is a variable-speed gas turbine, the physical parameters of the airstream (speed and/or flow) being obtained by means of permanent measurement and monitoring equipment comprising, inter alia, a suitable sensor with indicator in the circulation path of the air upstream from the turbine, and the powerful flow of air provided by the said apparatus is directed into the airtight substrate-holding chamber simultaneously with the screen-printing operation to transfer the said paste from the screen-printing screen on to the said substrate and to effect its deposition on the latter and its optimum coverage of the walls of the said holes and/or cavities, in conjunction with the action of the squeegee of the screen-printing device.

2. A process as claimed in Claim 1, characterized in that the measurement of the said physical parameters makes it possible to check the application of the paste in the direction of the thickness of the substrate and to modify its viscosity in accordance with the values of the other screen-printing parameters, the density and the dimension of the holes and/or cavities in the said substrate.

**Patentansprüche**

1. Verfahren zum Durchführen einer Vielzahl von Metallisierungen von Löchern oder Hohlräumen eines Substrats in Dickschichttechnik durch Siebdruckverfahren, wobei das genannte Substrat durch Erzeugen eines Unterdrucks in der luftdichten Kammer zum Tragen des Substrats in der Siebdruckeinrichtung, wobei die Viskosität der leitenden Paste einen geeigneten Wert hat und die Einsaugung der genannten Paste in die vorgebohrten Löcher und/oder Hohlräume mit einer Einrichtung erfolgt, die darin einen starken Luftstrom mit einem leichten Unterdruck erzeugen kann, dadurch gekennzeichnet, daß die Einrichtung, die dazu verwendet wird, Luft mit einem starken Strom und einem leichten Unterdruck umlaufen zu lassen, eine Gasturbine mit veränderlicher Geschwindigkeit ist, wobei die physikalischen Parameter des Luftstromes (Geschwindigkeit und/oder Flußmenge) mittels einer ständig wirkenden Meß- und Regeleinrichtung erhalten werden, die in der Luftumlaufstrecke stromaufwärts von der Turbine u.a. eine geeignete Sonde und Anzeigeeinrichtung aufweist, und daß der von der genannten Einrichtung gelieferte starke Luftstrom gleichzeitig mit dem Siebdruckvorgang zum Übertragen der genannten Paste von dem Siebdruckschirm auf das genannte Substrat zum Erhalten der Auftragung darauf und einer optimalen Bedeckung der Wände der genannten Löcher und/oder Hohlräume der genannten luftdichten Kammer zum Tragen des Substrats zugeführt wird, und zwar zusätzlich zu der Wirkung der Rakel der Siebdruckeinrichtung.

2. Verfahren nach Anspruch 1, dadurch gekennzeichnet, daß das Messen der genannten physikalischen Parameter die Kontrolle der Einführung der Paste in die Dicke des Substrats und die Änderung der Viskosität der Paste entsprechend den Werten der anderen Siebdruckparameter, der Dichte und der Größe der Löcher und/oder Hohlräume des genannten Substrats ermöglicht.

FIG.1

FIG.2